# EUROPEAN PATENT APPLICATION

(11) **EP 4 553 896 A2**
(43) Date of publication of application: **14.05.2025**
(21) Application number: 24209320.1
(22) Date of filing: 28.10.2024
(51) Int. Cl.: H01L 23/48, H01L 21/56, H01L 25/065

(54) **METHOD FOR MANUFACTURING INTEGRATED DEVICE PACKAGES**

(30) Priority: 09.11.2023 US 202318505154
(71) Applicant: ASMPT Singapore Pte. Ltd., Singapore 768924 (SG)
(72) Inventor: FAN, Chun Ho, Hong Kong Sar (CN); LI, Ming, Hong Kong Sar (CN); NG, Hoi Ping, Hong Kong Sar (CN); SO, Siu Cheung, Hong Kong Sar (CN)
(74) Representative: Emerson, Peter James

(57) **Abstract**

Preparation for fabricating an integrated device package is conducted by forming a first non-conductive dielectric layer on a first side of a plurality of dies and a first non-conductive dielectric layer on a first side of a carrier. The plurality of dies is bonded sequentially to the carrier by adhering the respective non-conductive dielectric layers to each other. A filling non-conductive dielectric layer is formed on the carrier and the plurality of dies until the plurality of dies is covered by the filling non-conductive dielectric layer. A portion of the filling non-conductive dielectric layer is then removed to planarize and expose conductive contact pads located on a second side of the plurality of dies opposite to the first side, to form a reconstituted die assembly which is electrically connectable to an external electronic device.

## Description

### Field of the Invention

The invention relates to processes for manufacturing integrated device packages, and in particular, to the bonding of multiple semiconductor dies to form integrated device packages.

### Background and Prior Art

Integrated device packages typically include one or more semiconductor dies mounted on a package substrate. With the advancement of assembly and packaging technology, semiconductor dies have increasingly finer pitch, and the challenge of electrically connecting such semiconductor dies to corresponding high-density bond pads or terminals is magnified. Moreover, as such bonding of electrical connections conventionally have to be conducted in very clean environments to avoid contamination, the flexibility of structuring manufacturing processes is reduced as a result of space constraints in a clean room.

In certain applications, there may be a need to bond individual singulated semiconductor dies onto a wafer or other substrate carrier, or an entire wafer containing multiple unsingulated semiconductor dies may be directly bonded onto another wafer or other substrate carrier. These semiconductor dies or wafers may be stacked in a three-dimensional arrangement and the respective dies are also typically arranged laterally relative to one another. Various combinations thereof are possible. The substrate carriers can also be provided with one or more redistribution layers, to provide greater spacing between bond pads than the pad pitches on the dies, in order to facilitate next-level interconnections with other electronic components.

It can be extremely challenging in the prior art to bond semiconductor dies (whether they comprise the same or different types of semiconductor dies) as described above in a clean environment. In order to maintain the required level of cleanliness when conducting the bonding operations, the clustering of multiple interconnected tools is one conventional solution. Using this approach, the interconnected tools are operative to conduct sequential bonding of multiple semiconductor dies as the wafer or substrate carrier is conveyed between the clustered tools to one another. In one prior art approach, a material preparation tool is used to treat the dies to be bonded and a target wafer with plasma gases in order to clean and activate them to prepare for subsequent die bonding. The dies and target wafer are then conveyed from the material preparation tool to one or more die bonding tools directly or indirectly connected to the material preparation tool using enclosed passageways in order to maintain the cleanliness of the dies and target wafer after the said cleaning and activation and during the said conveyance.

The clustering of material preparation and die bonding tools has various shortcomings. One is that the arrangement of the multiple tools occupies a large footprint and is expensive to operate. Especially if there are different types of dies to be mounted, the bonding of each type of die may require a different die bonder. Moreover, since the bonding of different dies is carried out sequentially within the cluster of tools, it is difficult to efficiently control the queue time, such that time might be wasted while a die bonding tool located downstream is waiting for a preceding bonding process to be completed.

It would be beneficial to be able to conduct the integration of multiple dies using standalone die bonders instead to avoid the above limitations of the prior art.

### Summary of the Invention

It is thus an object of the invention to seek to provide an improved manufacturing process or technique for mounting multiple semiconductor dies to form integrated device packages while meeting the required cleanliness requirements.

Accordingly, the invention provides a method of manufacturing an integrated device package, comprising the steps of: preparation of a plurality of dies for bonding by forming a first non-conductive dielectric layer on a first side of the plurality of dies; preparation of a carrier by forming a first non-conductive dielectric layer on a first side of the carrier; bonding the plurality of dies sequentially to the carrier by adhering the first non-conductive dielectric layer on the first side of the plurality of dies to the first non-conductive dielectric layer on the first side of the carrier; forming a filling non-conductive dielectric layer on the carrier and the plurality of dies bonded onto the carrier until the plurality of dies is covered by the filling non-conductive dielectric layer; removing a portion of the filling non-conductive dielectric layer to planarize and expose conductive contact pads located on a second side of the plurality of dies opposite to the first side to form a reconstituted die assembly, such that the conductive contact pads of the reconstituted die assembly are electrically connectable to an external electronic device.

It would be convenient hereinafter to describe the invention in greater detail by reference to the accompanying drawings which illustrate specific preferred embodiments of the invention. The particularity of the drawings and the related description is not to be understood as superseding the generality of the broad identification of the invention as defined by the claims.

### Brief Description of the Drawings

Specific examples of processes for manufacturing integrated device packages in accordance with the invention will now be described with reference to the accompanying drawings, in which:
FIGs. 1A to 1E illustrate the steps involved in a die preparation stage, including the formation of conductive bumps on dies, thinning and passivating a surface of the dies, and separating a die from other dies comprised in a wafer;
FIGs. 2A to 2C illustrate the steps involved in a carrier preparation stage, including fabricating alignment marks onto a surface of the carrier and passivating the surface of the carrier to prepare it for bonding;
FIGs. 3A and 3B illustrate the bonding of the dies prepared in FIGs. 1A to 1E to the carrier prepared in FIGs. 2A to 2C;
FIG. 4 illustrates the step of passivation of a surface of a fully-populated carrier bonded as shown in FIG. 3B with a non-conductive dielectric layer;
FIG. 5 illustrates the planarization of the fully-populated carrier in FIG. 4 to reveal copper bumps of the dies which have been bonded to it;
FIGs. 6A to 6C illustrate the bonding of the fully-populated carrier of FIG. 5 to a wafer according to one embodiment of the invention;
FIG. 7 shows an integrated device package constituted by two fully-populated carriers bonded together according to another embodiment of the invention;
FIG. 8 illustrates the bonding of respective separated dies to the fully-populated carrier according to one embodiment of the invention;
FIG. 9 illustrates the further formation of fan-out interconnects onto the fully-populated carrier according to one embodiment of the invention;
FIGs. 10A to 10G illustrate the steps involved in the preparation of a core die for use in multi-layer die stacking; and
FIGs. 11A to 11F is an exemplary illustration of how multiple core dies may be stacked onto one another to form a multi-layer integrated device package according to one embodiment of the invention.

### Detailed Description of the Preferred Embodiments of the Invention

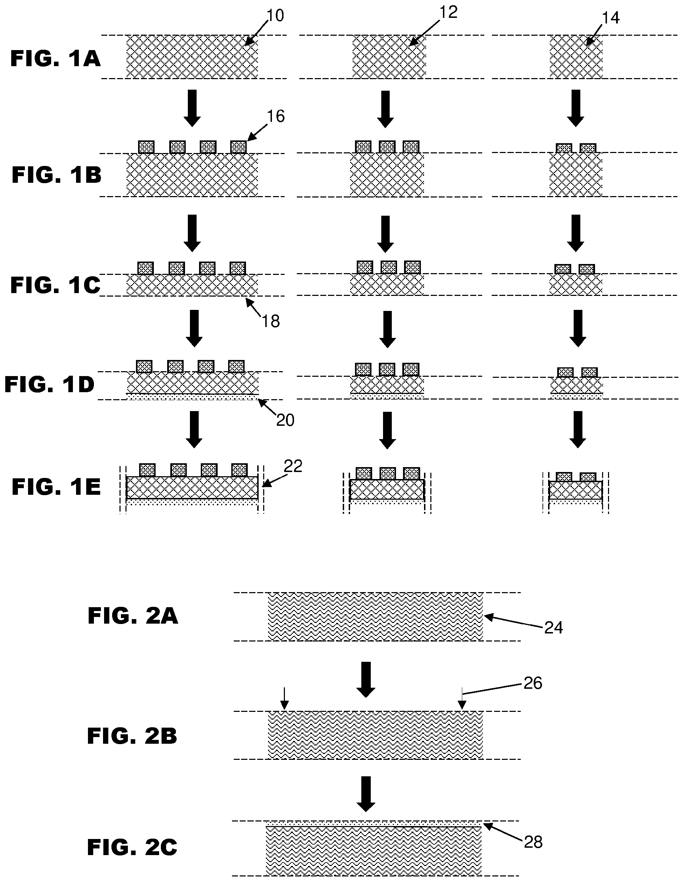

FIGs. 1A to 1E illustrate the steps involved in a die preparation stage. In FIG. 1A, a plurality of die that may be made up of multiple types of dies that are to be combined into an integrated device package are first selected. As an example, three types of dies referred to respectively as die A 10, die B 12 and die C 14 are selected. At this time, these different dies 10, 12, 14 are typically comprised in unsingulated wafers which contain the plurality of dies to allow batch processing. Thus, the said die A 10, die B 12 and die C 14 are each comprised in a separate wafer, each of which has an array of unsingulated dies.

In FIG. 1B, conductive contact pads, such as copper bumps 16, have been formed on bond pads of the respective dies 10, 12, 14, typically by way of electroplating copper material onto the bond pads of these dies. In FIG. 1C, bottom surfaces on first sides of the wafers (opposite to top surfaces on second sides thereof on which the copper bumps 16 have been formed) are grinded to form thinned wafer surfaces 18. Such grinding may be conducted first by mechanical grinding followed by chemical-mechanical polishing ("CMP") of the bottom surfaces of the wafers.

To prepare for the mounting of a collection of the different dies 10, 12, 14 onto fixed positions relative to one another on a carrier, FIG. 1D shows a non-conductive dielectric layer 20 that is formed onto the each of thinned wafer surfaces 18 after grinding. The non-conductive dielectric layer 20 may comprise non-conductive materials that may include but are not limited to as silicon oxide, silicon nitride, or silicon oxynitride, or can include carbon, such as silicon carbide, silicon oxycarbonitride, silicon carbonitride or diamond-like carbon.

With an appropriate set-up, these materials may be deposited onto wafers by way of thin film deposition processes, including but not limited to physical vapor deposition processes and chemical vapor deposition processes. In particular, thin film deposition of these materials by plasma-enhanced chemical vapor deposition (or PECVD) is preferred. Thin film deposition is typically followed by polishing the surface of the deposited non-conductive dielectric layer by CMP. Thereafter, as shown in FIG. 1E, the individual dies 10, 12, 14 are singulated from the wafers that they were comprised in, by way of a singulation process such as saw blade dicing or laser dicing, so that each singulated die 10, 12, 14 has singulated surfaces 22 separating it from other dies from the same wafer.

Although the non-conductive dielectric layer 20 may comprise organic or inorganic dielectric materials, the use of only inorganic dielectric materials are preferred since their coefficients of thermal expansion are more similar to that of the silicon dies 10, 12 and 14. This ensures that the dies 10, 12, 14 would be less prone to coefficient of thermal expansion mismatch-induced issues such as warpage when subjected to high temperatures.

FIGs. 2A to 2C illustrate the steps involved in a carrier preparation stage. In FIG. 2A, a carrier 24 is first selected for the mounting of the dies 10, 12, 14 that have been prepared in FIG. 1E. The carrier 24 is in a planar form, and it may be made from various materials such as silicon or glass. After selection of the carrier 24, in FIG. 2B, alignment marks 26 are fabricated onto a top side of the carrier 24 at designated locations for alignment purposes. These alignment marks 26 may be used later to aid in the accurate mounting of the plurality of dies 10, 12, 14 onto specific locations on the carrier 24. As shown in FIG. 2C, to prepare the carrier 24 for mounting of the dies 10, 12, 14 onto it, a first or top side of the carrier 24 is passivated by forming a non-conductive dielectric layer 28 onto it. Such passivation may be conducted using similar non-conductive materials as those used for the non-conductive dielectric layers 20 described above that have been formed onto the dies 10, 12, 14. The surface of the deposited non-conductive dielectric layer 28 is then polished by CMP.

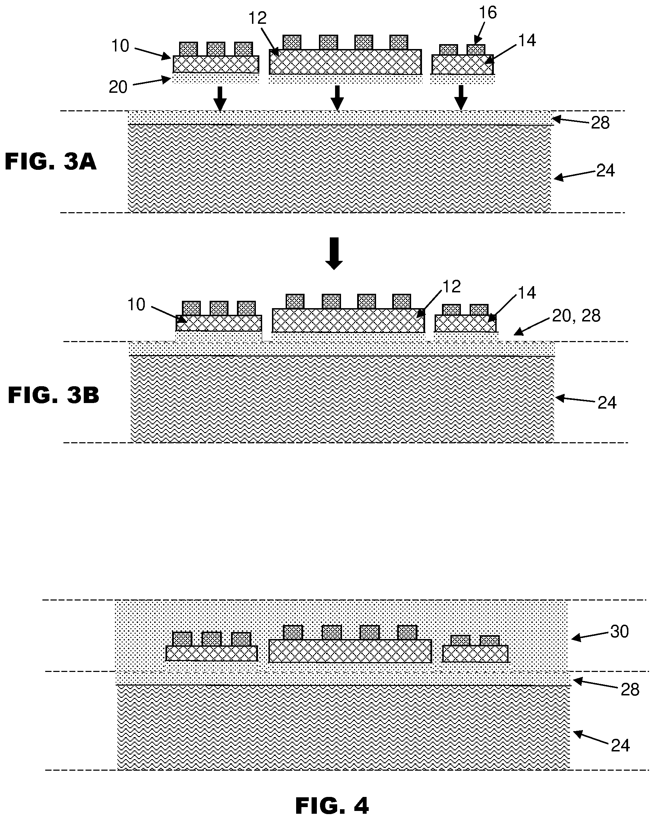

FIGs. 3A and 3B illustrate the bonding of the dies prepared in FIGs. 1A to 1E to the carrier prepared in FIGs. 2A to 2C. In order to avoid manufacturing defective electronic devices, only known good dies from the plurality of dies that have been separated should be selected for bonding onto the carrier 24. In FIG. 3A, known good dies belonging to die A 10, die B 12 and die C 14 are bonded onto predetermined positions on the carrier 24. These singulated dies 10, 12, 14 are bonded sequentially onto the carrier 24 with reference to the alignment marks 26 that were previously fabricated onto the top surface of the carrier 24.

The dies 10, 12, 14 are bonded onto the carrier 24 with their copper bumps 16 facing upwards away from the carrier 24. Thus, the non-conductive dielectric layer 20 on the dies 10, 12, 14 are in contact with the non-conductive dielectric layer 28 on the carrier 24 to achieve direct dielectric-to-dielectric bonding via the respective non-conductive dielectric layers 20, 28 that were formed during the earlier die preparation and carrier preparation steps, when the dies 10, 12, 14 are being populated onto the carrier 24.

As shown in FIG. 3B, the dielectric-to-dielectric bonds are annealed in an appropriate environment (such as at a high temperature and after the purging of atmospheric gases by nitrogen gas) in order to adhere the respective non-conductive dielectric layers 20, 28 together, so as to solidify the bonds and to fix the positions of the dies 10, 12, 14 relative to one another.

FIG. 4 illustrates the step of passivation of a surface of a fully-populated carrier 24 bonded as shown in FIG. 3B with a further filling non-conductive dielectric layer 30added on top of the carrier 24 and the dies 10, 12, 14. This additional filling non-conductive dielectric layer 30 will not only fill any gaps between the dies 10, 12, 14 that have been arranged on the carrier 24, but will also be topped up to a level that covers all the copper bumps 16 on the dies 10, 12, 14.

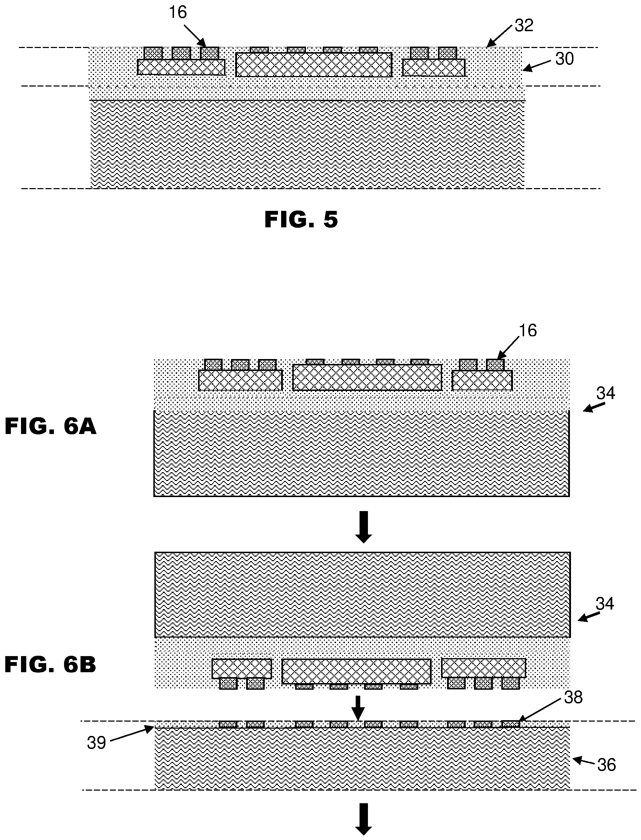

FIG. 5 illustrates the planarization of the fully-populated carrier 24 in FIG. 4 to reveal the conductive contact pads or copper bumps 16 of the dies 10, 12, 14 which have been bonded to it. Planarization may be conducted by grinding of the non-conductive dielectric layer using CMP to remove a portion of the filling non-conductive dielectric layer 30, until all the copper bumps 16 are exposed on a top surface of the grinded filling non-conductive dielectric layer 30. Hence, the top surfaces of the copper bumps 16 and the filling non-conductive dielectric layer 30 are flush with one another, to enable such a planarized reconstituted die assembly 34 to be electrically connectable to an external electric device, as further explained below.

It should be appreciated that the different types of dies 10, 12, 14 would inherently have different thickness tolerances, while the copper bumps 16 formed on the dies 10, 12, 14 also have height tolerances. The benefit of the planarization step in FIG. 5 is that, by appropriate designing of the die thickness and bump height tolerances, the process ensures that all the exposed surfaces of the copper bumps 16 are uniformly located at the same level to facilitate their subsequent bonding to other devices notwithstanding any inherent differences in thickness and height.

FIGs. 6A to 6C illustrate the bonding of a planarized reconstituted die assembly 34 (formed from the fully-populated carrier 24 of FIG. 5) to a wafer 36 according to one embodiment of the invention. In FIG. 6A, the exposed copper bumps 16 of the planarized reconstituted die assembly 34 are facing up. In FIG. 6B, the planarized reconstituted die assembly 34 is inverted so that its exposed copper bumps 16 face corresponding conductive contacts 38 that have been formed on the wafer 36. The conductive contacts 38 of the wafer 36 may be surrounded by a non-conductive dielectric layer 39.

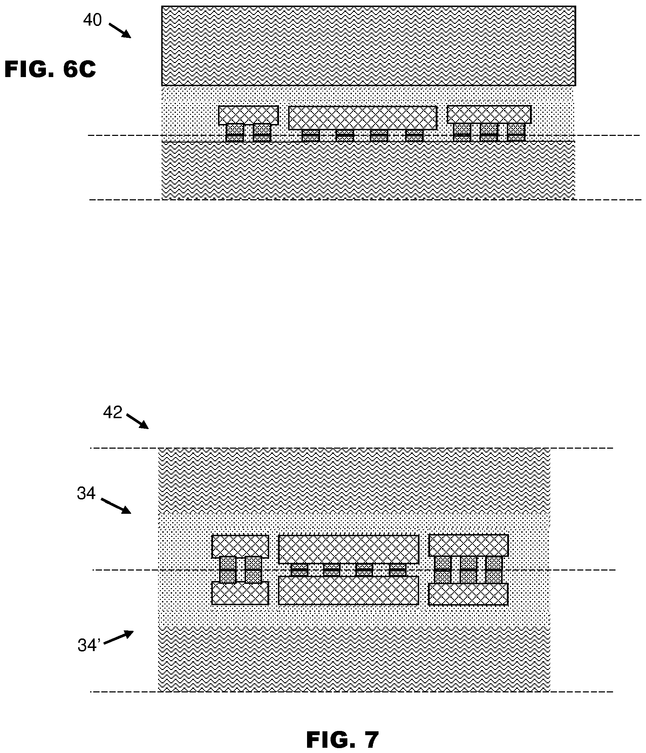

The exposed copper bumps 16 of the planarized reconstituted die assembly 34 are then aligned and placed into contact with the conductive contacts 38 of the wafer 36 as shown in FIG. 6C, and the adhesion between the respective non-conductive dielectric layers 30, 39 is solidified by annealing. This completes the fabrication of an integrated device package 40 that is constituted by the planarized reconstituted die assembly 34 bonded to the wafer 36. The resulting structure can be processed through downstream processes to create a final device structure which is electrically connectable to other electronic devices.

FIG. 7 shows an integrated device package 42 constituted by two fully-populated carriers in the form of two planarized reconstituted die assemblies 34, 34' that are similar to each other. They are bonded together according to another embodiment of the invention. The copper bumps 16 of the two planarized reconstituted die assemblies 34, 34' are aligned and bonded to each other in the manner illustrated in FIG. 6C, to fabricate an integrated device package 42. Since the preparation and assembly of each planarized reconstituted die assembly 34, 34' may be conducted using the same process as that already described above, a detailed description of the process will not be repeated here. The resulting structure can be processed through downstream processes to create a final device structure which is electrically connectable to other electronic devices.

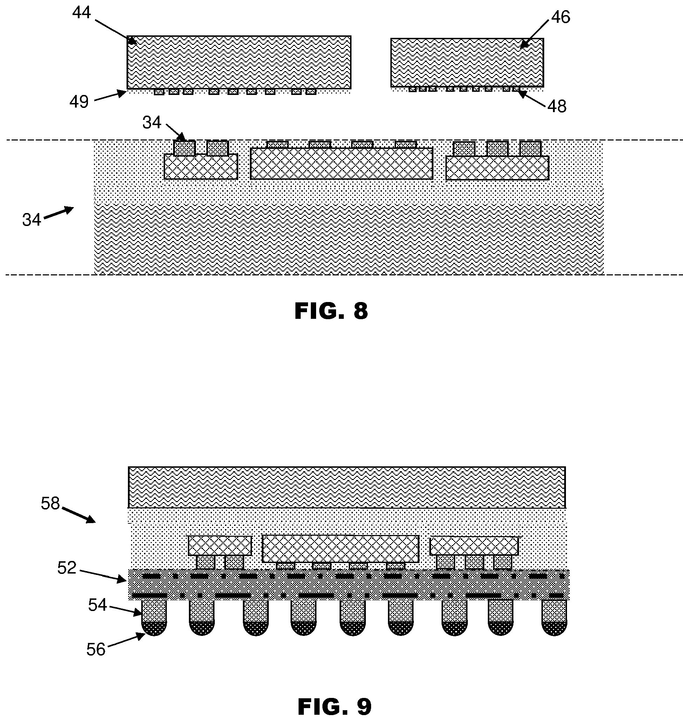

FIG. 8 illustrates the bonding of respective separated dies from a second plurality of dies, namely die D 44 and die E 46 to the fully-populated carrier 24 in the form of the planarized reconstituted die assembly 34 according to one embodiment of the invention. In order to achieve dielectric-to-dielectric bonding, the conductive contact pads or copper bumps 48 of these dies 44, 46 are surrounded by a non-conductive dielectric layer 49 that is flush with exposed surfaces of the copper bumps 48. Singulated known good dies belonging to die D 44 and die E 46 are sequentially bonded onto predetermined positions on the planarized reconstituted die assembly 34 using direct dielectric-to-dielectric bonding via the respective non-conductive dielectric layers 30, 49. These singulated dies 44, 46 may be bonded onto the planarized reconstituted die assembly 34 with reference to the exposed copper bumps 16 on the top surface of the planarized reconstituted die assembly 34, or separate alignment marks may be added to the planarized reconstituted die assembly 34 for alignment purposes. An integrated device package so fabricated combines the planarized reconstituted die assembly 34 and the second plurality of dies 44, 46. The resulting structure can be processed through downstream processes to create a final device structure which is electrically connectable to other electronic devices.

FIG. 9 illustrates the further formation of fan-out interconnects onto the fully-populated carrier in the form of the planarized reconstituted die assembly 34 according to one embodiment of the invention. The said fan-out interconnects may include one or more redistribution layers 52 that electrically couple the copper bumps 16 which have smaller separation pitches to copper pillars 54 on an opposite side of the one or more redistribution layers 52 from the copper bumps 16. Each copper pillar 54 may be further topped off with a solder bump 56 to create electrical contacts for next-level interconnection via the fan-out interconnects at the positions of the solder bumps 56. Such an integrated device package 56 which is fabricated by combining the planarized reconstituted die assembly 34, one or more redistribution layers 52 and electrical contacts can be electrically mounted to other electronic devices.

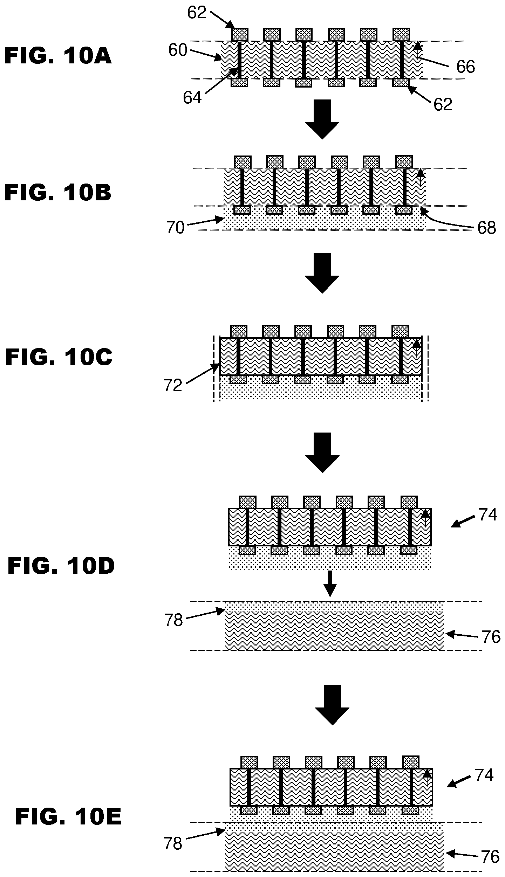

FIGs. 10A to 10G illustrate the steps involved in the preparation of a core die 60 for use in multi-layer die stacking. The selected core die 60 as shown in FIG. 10A is part of a wafer including a plurality of integrated core dies 60 that is in a matrix arrangement. Each core die 60 has multiple through-silicon vias ("TSVs") that pass through an entire thickness of the core die 60. Each TSV 64 is filled with a conductive material (such as copper) and conductive contact pads (such as copper bumps 62) are formed on opposite sides of the TSVs. A top surface of the core die 60 is marked with an arrow 66 in FIG. 10A.

In FIG. 10B, a non-conductive dielectric layer 70 that covers the conductive bumps 62 is formed onto a bottom surface 68 on a first side of the core die 60. In FIG. 10C, each core die 60 is singulated from a wafer which it is a part of, so that there are singulated surfaces 72 on each core die 60. If the core die 60 is a good one and is not defective, the singulated core die 60 can be referred to as a known good core die 74, as shown in FIG. 10D. The known good core die 74 is then bonded to a carrier 76 on which a corresponding non-conductive dielectric layer 78 has been formed. Such carrier 76 may be made from silicon, glass or other suitable material.

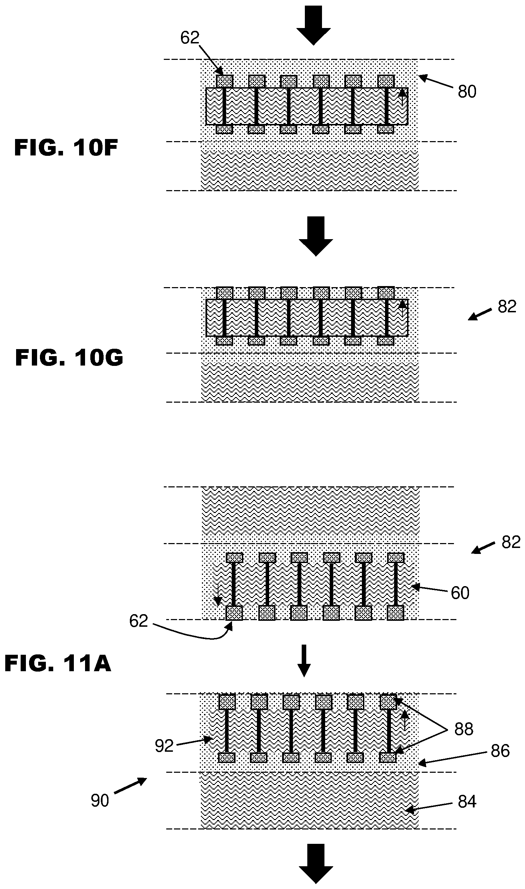

FIG. 10E shows the known good core die 74 that has been bonded to the carrier 76 using direct dielectric-to-dielectric bonding. FIG. 10F shows another non-conductive dielectric layer 80 being formed on the top surface (indicated by arrow 66) of the core die 60 to fill up gaps between the respective conductive bumps 62 and to top up the non-conductive dielectric layer 80 to cover all the conductive bumps 62.

In FIG. 10G, the non-conductive dielectric layer 80 is grinded until top surfaces of the conductive bumps 62 are exposed, and the surfaces of the non-conductive dielectric layer 80 and the conductive bumps 62 are flush with one another, which results in a planarized reconstituted die assembly 82 that includes the core die 60.

FIGs. 11A to 11F is an exemplary illustration of how multiple core dies 60, 94 may be stacked onto one another to form a multi-layer integrated device package 100 according to one embodiment of the invention. As illustrated in FIG. 11A, there is a second or bottom reconstituted die assembly 90 that may contain a bottom die 92 bonded to a carrier 84 via a non-conductive dielectric layer 86. A structure of the bottom reconstituted die assembly 90 is similar to that of the planarized reconstituted die assembly 82. The bottom die 92 has copper bumps 88 on a bottom surface that is covered by the non-conductive layer 86, and exposed copper bumps 88 on its top surface.

The exposed conductive bumps 62 on the planarized reconstituted die assembly 82 including the core die 60 are aligned with the exposed conductive bumps 88 on the upper surface of the bottom die 92. Thereafter, the planarized reconstituted die assembly 82 containing the core die 60 is bonded to the top surface of the bottom planarized reconstituted die assembly 90 containing the bottom die 92 so that the conductive bumps 62 are in electrical contact with the corresponding conductive bumps 88.

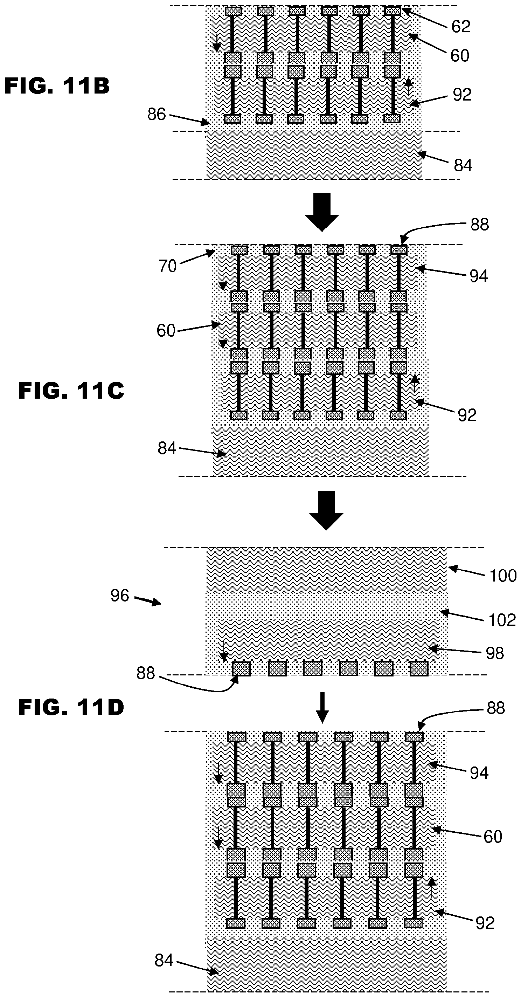

FIG. 11B shows an integrated device package 82 that has been bonded to the integrated device package containing the bottom die 92. Moreover, the carrier 76 and part of the non-conductive dielectric layer 78 of the planarized reconstituted die assembly 82 have been removed to expose top surfaces of the conductive pads 62 of the core die 60.

Thereafter, FIG. 11C shows a further second core die 94 having copper bumps 88 that has been bonded and electrically connected to top surfaces of the conductive pads 62 of the core die 60. The manner of dielectric-to-dielectric bonding may be similar as that described in relation to FIGs. 1A and 1B, wherein a further reconstituted die assembly (not shown) containing the second core die 94 is bonded on top of the core die 60. The carrier and part of the non-conductive dielectric layer of said integrated device package containing the second core die 94 is then grinded to expose the copper bumps 88 on its top surface. This stacked assembly therefore includes three separate layers of stacked dies 92, 60, 94, as shown in FIG. 11C.

In FIG. 11D, a top reconstituted die assembly 96 comprising a top die 98 that is mounted on a carrier 100 via a non-conductive dielectric layer 102 is inverted such that its copper bumps 88 are facing the copper bumps 88 of the second core die 94. The manufacturing process used to form such an integrated device package 96 may be similar to that used to form the integrated device package in the form of the reconstituted die assembly 34 illustrated in FIG. 6A.

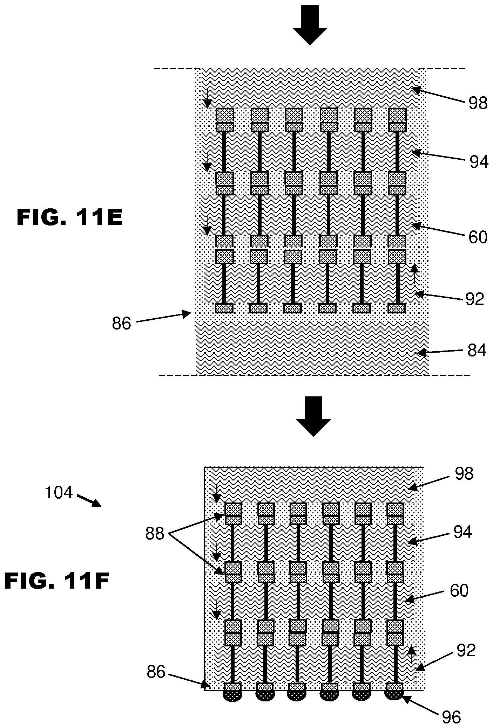

In FIG. 11E, the top die 98 has been bonded and electrically connected to the second core die 94 via dielectric-to-dielectric bonding to couple the respective copper bumps 88. Further, the carrier 100 and non-conductive dielectric layer 102 of the top die 98 have been fully grinded to expose a top surface of the top die 98. Hence, top surface of a plurality of top dies 98 would have been removed.

In FIG. 11F, the carrier 84 and a portion of the non-conductive dielectric layer 86 of the bottom reconstituted die assembly 90 have been removed by grinding to expose copper bumps 88 on a lower surface of the bottom die 92. Solder bumps 96 are then deposited onto these exposed copper bumps 88 on the lower surface of the bottom die 92. The fabricated multi-layer integrated device package 104 including the top die 98 of the top reconstituted die assembly 96, one or more core dies 60, 94, and the bottom die 92 of the bottom reconstituted die assembly 90 may now be singulated to separate its respective electronic devices for electrical testing. Thereafter, these singulated and tested electronic devices will be ready to be electrically mounted to other electronic devices using the solder bumps 96 as electrical interconnects, for the next level of device interconnection.

It should be appreciated that the manufacturing processes in accordance with the preferred embodiments of the invention present an architecture, method and process flow which enables an effective way of integrating multiple dies to form an integrated device package. The multiple dies may be of same or different types, and standalone die bonders may be utilized without the need to cluster a preparation tool and mulitple die bonders together to handle materials such as multiple dice and target wafers. As a result, control of both the cleanliness of the material and manufacturig queue time are improved. The aforesaid approach avoids the need for the clustering of multiple tools that has led to serious individual tool utilization performance shortfalls as well as unnecessarily complicated operations in the prior art, especially for integrating multiple dies of different die types.

Moreover, a much larger process window is availlable as there is less time limitation imposed by queueing time and the need for a strictly sequential integrated assembly line. Hence, there is increased flexibility to handle single-layer and multi-layer three-dimensional integrated device packages using either the integration of single or multiple chiplets (whether active or non-active) and/or die stacking. Parallel processing is enabled, to avoid the strictly sequential mode of operation in the prior art. This enablement can greatly improve productivity.

By avoiding the use of organic dielectric material in the non-conductive dielectric layer, mismatches of coefficient of thermal expansion that might induce warpage or die-shift issues can be further reduced. Moreover, planarization by grinding using CMP or other surface removal technology on the integrated device package would assist next-level interconnection to be made in downstream processes for the integrated device packages by overcoming any die thickness or height variations, especially in devices with multiple chiplets.

The invention described herein is susceptible to variations, modifications and/or additions other than those specifically described and it is to be understood that the invention includes all such variations, modifications and/or additions which fall within the spirit and scope of the above description.

## Claims

1. Method of manufacturing an integrated device package, comprising the steps of:
preparation of a plurality of dies for bonding by forming a first non-conductive dielectric layer on a first side of the plurality of dies;
preparation of a carrier by forming a first non-conductive dielectric layer on a first side of the carrier;
bonding the plurality of dies sequentially to the carrier by adhering the first non-conductive dielectric layer on the first side of the plurality of dies to the first non-conductive dielectric layer on the first side of the carrier;
forming a filling non-conductive dielectric layer on the carrier and the plurality of dies bonded onto the carrier until the plurality of dies is covered by the filling non-conductive dielectric layer;
removing a portion of the filling non-conductive dielectric layer to planarize and expose conductive contact pads located on a second side of the plurality of dies opposite to the first side to form a reconstituted die assembly, such that the conductive contact pads of the reconstituted die assembly are electrically connectable to an external electronic device.

2. The method as claimed in claim 1, wherein the preparation of the plurality of dies further comprises the steps of:
forming the first non-conductive dielectric layer on a first side of a wafer which contains the plurality of dies; and
singulating the wafer to separate the plurality of dies.

3. The method as claimed in claim 2, further comprising the step of forming the conductive contact pads on a second side of the wafer opposite to the first side, and grinding the first side of the wafer to thin the wafer prior to forming the first non-conductive dielectric layer on the first side of the wafer.

4. The method as claimed in claim 2, further comprising the step of selecting only known good dies from the plurality of dies that have been separated to be bonded onto the carrier.

5. The method as claimed in claim 1, wherein the first non-conductive dielectric layers on the first sides of the plurality of dies and the carrier consist only of an inorganic dielectric material.

6. The method as claimed in claim 1, wherein the preparation of the plurality of dies further comprises the steps of:
forming the first non-conductive dielectric layer on first sides of multiple wafers of different types containing the plurality of dies of different types; and
singulating the multiple wafers to separate the plurality of dies of different types for bonding.

7. The method as claimed in claim 1, wherein the first non-conductive dielectric layers on the first sides of the plurality of dies and the carrier are deposited by plasma-enhanced chemical vapor deposition.

8. The method as claimed in claim 1, wherein the preparation of the carrier further comprises the step of fabricating alignment marks on the first side of the carrier for alignment purposes during bonding of the plurality of dies onto the carrier.

9. The method as claimed in claim 1, wherein the first non-conductive dielectric layer on the plurality of dies is adhered to the first non-conductive dielectric layer on the carrier by annealing the respective non-conductive dielectric layers to each other to solidify their dielectric-to-dielectric bonding and to fix their relative positions.

10. The method as claimed in claim 1, wherein the filling non-conductive dielectric layer is planarized such that top surfaces of the conductive contact pads and the filling non-conductive dielectric layer are flush with one another.

11. The method as claimed in claim 1, further comprising providing a wafer having a non-conductive dielectric layer surrounding conductive contacts of the wafer, and bonding the conductive pads of the reconstituted die assembly to the conductive contacts, such combination of the reconstituted die assembly and the wafer forming the integrated device package.

12. The method as claimed in claim 1, further comprising providing a second reconstituted die assembly that is similar to the reconstituted die assembly, and bonding the conductive contact pads of the reconstituted die assembly to conductive contact pads of the second reconstituted die assembly, such combination of the reconstituted die assembly and the second reconstituted die assembly forming the integrated device package.

13. The method as claimed in claim 1, further comprising providing a second plurality of separated dies having a non-conductive dielectric layer surrounding conductive contact pads of each of the second plurality of separated dies, and bonding the second plurality of separated dies to electrically connect the contact pads of the second plurality of separated dies to the conductive contact pads of the reconstituted die assembly, such combination of the reconstituted die assembly and the second plurality of separated dies forming the integrated device package.

14. The method as claimed in claim 1, further comprising forming one or more redistribution layers onto the planarized filling non-conductive dielectric layer for electrically coupling the conductive contact pads to electrical contacts formed on an opposite side of the one or more redistribution layers from the conductive contact pads, such combination of the reconstituted die assembly, the one or more redistribution layers and the electrical contacts forming the integrated device package.

15. The method as claimed in claim 1, wherein preparation of the plurality of dies further comprises the steps of forming multiple through-silicon vias filled with a conductive material in each die, and forming the conductive contact pads on opposite sides of the through-silicon vias, prior to forming the first non-conductive dielectric layer on the first side of each die, the first non-conductive dielectric layer covering the conductive contact pads on the first side of each die for bonding each die to the carrier.

16. The method as claimed in claim 15, wherein after forming the reconstituted die assembly, providing a second reconstituted die assembly which is similar to the reconstituted die assembly, and bonding the conductive contact pads of the second reconstituted die assembly to the conductive contact pads of the reconstituted die assembly.

17. The method as claimed in claim 16, further comprising removing the carrier and a portion of the non-conductive dielectric layer of the reconstituted die assembly, in order to expose the conductive contact pads of the reconstituted die assembly that are flush with a top surface of a portion of the non-conductive dielectric layer that remains which has not been removed.

18. The method as claimed in claim 17, wherein after exposing the conductive contact pads of the reconstituted die assembly, providing a third reconstituted die assembly which is similar to the reconstituted die assembly, and bonding the conductive contact pads of the third reconstituted die assembly to the conductive contact pads of the reconstituted die assembly.

19. The method as claimed in claim 17, further comprising providing a second plurality of dies mounted onto a second carrier via a second non-conductive dielectric layer, and bonding the second plurality of dies to electrically connect conductive contacts of the second plurality of dies to the conductive contact pads of the reconstituted die assembly.

20. The method as claimed in claim 19, further comprising the steps of:
removing the carrier and a portion of the non-conductive dielectric layer of the second reconstituted die assembly in order to expose the conductive contact pads of the plurality of dies of the second reconstituted die assembly that are flush with a surface of a portion of the non-conductive dielectric layer that remains which has not been removed; and
removing the second carrier and second non-conductive dielectric layer to expose a surface of the second plurality of dies;
wherein such combination of the reconstituted die assembly, the second reconstituted die assembly and the second plurality of dies forms the integrated device package.
